(19) Europäisches Patentamt
European Patent Office
Office européen des brevets

(11) **EP 3 732 126 B1**

(12) **FASCICULE DE BREVET EUROPEEN**

(45) Date de publication et mention de la délivrance du brevet:
**10.05.2023 Bulletin 2023/19**

(21) Numéro de dépôt: **18825720.8**

(22) Date de dépôt: **21.12.2018**

(51) Classification Internationale des Brevets (IPC):
**B81B 3/00** *(2006.01)*    **H01H 59/00** *(2006.01)*

(52) Classification Coopérative des Brevets (CPC):
**B81B 3/0016; H01H 59/0009;** B81B 2201/016

(86) Numéro de dépôt international:
**PCT/EP2018/086634**

(87) Numéro de publication internationale:
**WO 2019/129720 (04.07.2019 Gazette 2019/27)**

(54) **COMMUTATEUR MEMS-RF COMPORTANT DES ELEMENTS INCLUANT UN MATERIAU FERROMAGNETIQUE**

RF-MEMS-SCHALTER MIT FERROMAGNETISCHEM MATERIAL ENTHALTENDEN ELEMENTEN

RF-MEMS SWITCH COMPRISING ELEMENTS INCLUDING A FERROMAGNETIC MATERIAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.12.2017 FR 1701394**

(43) Date de publication de la demande:
**04.11.2020 Bulletin 2020/45**

(73) Titulaire: **THALES**
**92400 Courbevoie (FR)**

(72) Inventeurs:
• **LE BAILLIF, Matthieu**
**91767 Palaiseau Cedex (FR)**
• **CZARNY, Romain**
**91767 Palaiseau Cedex (FR)**
• **LEBOURGEOIS, Richard**
**91767 Palaiseau Cedex (FR)**

(74) Mandataire: **Atout PI Laplace**
**Immeuble "Visium"**
**22, avenue Aristide Briand**
**94117 Arcueil Cedex (FR)**

(56) Documents cités:
**WO-A1-2015/199721    US-A1- 2005 248 423**

**Description**

Le domaine de l'invention est celui des commutateurs dits « MEMS-RF », acronyme signifiant « MicroElectroMechanical System - Radio Frequency ». Ce type de commutateur comporte des éléments mécaniques de dimensions submillimétriques dont les micro-déplacements commandés par des moyens électroniques permettent de réaliser des fonctionnalités radiofréquence.

Dans un grand nombre d'applications, l'élément mobile du commutateur est une membrane métallique disposée au-dessus d'une électrode plane recouverte d'un matériau diélectrique. Sous l'effet d'un champ électrostatique, la membrane se déforme et entre en contact avec l'électrode assurant ainsi la fonctionnalité souhaitée. Actionner/relâcher cette membrane électrostatique revient à charger/décharger une capacité. Dans un cas comme dans l'autre, un courant est généré lors de ces phases. Ce courant de faible intensité est émis sur une très courte période. Un exemple de commutateur MEMS-RF capacitif est décrit dans US 2005/248423 A1.

Un des inconvénients de ce type de commutateur est qu'un des facteurs de défaillance est l'auto-maintien de la membrane sur son électrode, même lorsque le courant est coupé, rendant le dispositif inutilisable. Cet auto-maintien a deux causes principales. La première est l'injection de charges dans la partie supérieure du diélectrique et la seconde les effets de collage dus aux forces de Van der Waals à mesure que la qualité de surface du diélectrique s'améliore, sa rugosité étant de plus en plus faible. Le document WO 2015/199721 A1 montre un exemple de commutateur NEMS utilisant des matériaux ferroélectriques pour surmonter le collage du aux forces de Van der Waals.

Plusieurs études ont montré que, lorsque la membrane du commutateur capacitif est à l'état bas, des charges sont injectées dans la partie supérieure de la couche diélectrique. En effet, lorsque la membrane du MEMS-RF à actionnement électrostatique est à l'état bas, l'empilement ligne/diélectrique/membrane forme une capacité « MIM », signifiant « Metal-Insulator-Metal », comprenant généralement une capacité d'air parasite au niveau du contact membrane/diélectrique due à la rugosité des matériaux. Le diélectrique de cette capacité MIM se charge rapidement sur sa partie inférieure et peu sur sa partie supérieure à cause du mauvais contact métal/diélectrique. Lors de la phase de relâchement ou de décharge, le contact cesse sur la partie supérieure du diélectrique et les charges injectées restent prisonnières tandis que dans la partie inférieure, les charges sont évacuées grâce au très bon contact diélectrique /métal. Après de multiples activations, ces charges sont présentes en quantité suffisantes pour générer un champ électrique résiduel statique maintenant la membrane à l'état bas.

Cet effet varie fortement avec le niveau de champ électrique présent dans le diélectrique lorsque la membrane est maintenue à l'état bas. Ainsi, les effets de ce chargement de la partie supérieure du diélectrique ne sont pas observés au même moment pour des structures ayant des tensions d'activation différentes.

Pour pallier cet inconvénient, plusieurs solutions techniques ont été proposées. L'augmentation de la force de rappel fait partie des plus couramment utilisées. La membrane étant plus raide, on doit augmenter le stress électrique dans le diélectrique pour obtenir la montée ou la descente de la membrane. Cette augmentation de la force de rappel est alors limitée par la tension de claquage du matériau diélectrique.

Une autre solution consiste à introduire un mécanisme de « pull-up » forçant la membrane à remonter au moyen d'un actionneur électrostatique. Cette solution a comme principal inconvénient de compliquer la structure mécanique et, par conséquent de diminuer sa fiabilité.

Une dernière solution consiste à réduire la tension nécessaire à l'activation et au maintien de la membrane du MEMS-RF à l'état bas. Cette solution permet de réduire fortement le stress électrique subi par le diélectrique et son vieillissement. Cette solution n'est, malheureusement, pas compatible des applications de puissance qui, à cause de l'effet d'auto-activation, nécessitent un minimum de raideur de la membrane, fonction de la puissance du signal que l'on souhaite faire transiter par le composant MEMS-RF.

On sait que tout courant électrique circulant dans un conducteur génère un champ magnétique. On sait également que ce champ magnétique peut exercer une force magnétostatique sur certains matériaux ferromagnétiques. Le commutateur selon l'invention met en oeuvre ces propriétés. En disposant judicieusement les lignes de commande électriques et en utilisant des matériaux ferromagnétiques dans la réalisation de l'électrode et de la membrane, on peut ainsi créer des forces magnétiques soit attractives, soit répulsives qui vont aider la membrane soit à se coller contre l'électrode, soit à s'en détacher. Plus précisément, l'invention a pour objet un commutateur MEMS-RF selon la revendication 1. Ce commutateur comporte une membrane métallique disposée au-dessus d'une électrode de commande, caractérisé en ce que la membrane et l'électrode de commande sont réalisées en matériaux ferromagnétiques ou comportent au moins une couche de matériau ferromagnétique. Aux instants de commutation de l'électrode de commande, une force magnétique de rappel est générée sur la membrane par un champ magnétique généré par un courant transitoire circulant auxdits instants de commutation.

Avantageusement, au repos, la membrane étant sensiblement plane et maintenue au-dessus de l'électrode de commande par deux piliers, la déformation de la membrane se faisant selon un axe perpendiculaire à ce plan et selon une direction joignant les deux piliers, l'électrode de commande étant alimentée par une ligne de commande en courant, ladite ligne de commande est disposée de façon que le sens de l'intensité du courant soit perpendiculaire audit axe et à ladite direction de façon que les forces magnétiques créées par ledit courant soient parallèles à l'axe de déformation.

Avantageusement, le matériau ferromagnétique de la membrane possède une aimantation permanente appelée aimantation rémanente.

Avantageusement, le matériau ferromagnétique de la membrane est un alliage de samarium-cobalt ou un alliage de néodyme-fer-bore ou un hexaferrite de baryum ou de strontium.

Avantageusement, le matériau ferromagnétique de l'électrode de commande est un alliage conducteur en fer-nickel.

Avantageusement, le matériau ferromagnétique de l'électrode de commande est un ferrite isolant.

Avantageusement, le ferrite isolant est un ferrite spinelle de nickel-zinc.

Avantageusement, la couche de matériau ferromagnétique est déposée par évaporation sous vide ou par pulvérisation cathodique ou par dépôt par ablation laser.

Avantageusement, l'épaisseur de la membrane est comprise entre 0.5 micromètre et 1.5 micromètre.

Avantageusement, l'épaisseur de la couche de matériau ferromagnétique de l'électrode est comprise entre 100 nanomètres et 300 nanomètres.

Avantageusement, la largeur de la membrane est comprise entre 50 micromètres et 150 micromètres et sa longueur est comprise entre 200 micromètres et 400 micromètres.

L'invention sera mieux comprise et d'autres avantages apparaîtront à la lecture de la description qui va suivre donnée à titre non limitatif et grâce aux figures annexées parmi lesquelles :

La figure 1 représente une vue de dessus et une vue de face d'un commutateur MEMS-RF selon l'art antérieur ;

Les figures 2 à 4 représentent les différentes étapes d'une activation électrostatique d'un MEMS-RF permettant de passer de l'état « ouvert » à l'état « fermé » ;

Les figures 5 à 7 représentent les différentes étapes d'une activation électrostatique d'un MEMS-RF permettant de passer de l'état « fermé » à l'état « ouvert » ;

La figure 8 représente les lignes de champ magnétique dans un conducteur électrique ;

La figure 9 représente une vue de dessus d'un commutateur MEMS-RF selon l'invention ;

Les figures 10 et 11 représentent respectivement les effets de répulsion et d'attraction qui sont présents respectivement lors des passages de l'état bas à l'état haut et de l'état haut à l'état bas ;

La figure 12 représente les trois forces en fonction du temps s'exerçant sur la membrane lorsqu'elle est soumise à une désactivation ;

La figure 13 représente, en fonction du temps, la résultante de ces trois forces s'exerçant sur la membrane lorsqu'elle est soumise à une désactivation ainsi que la comparaison avec une membrane ne comportant pas le dispositif selon l'invention.

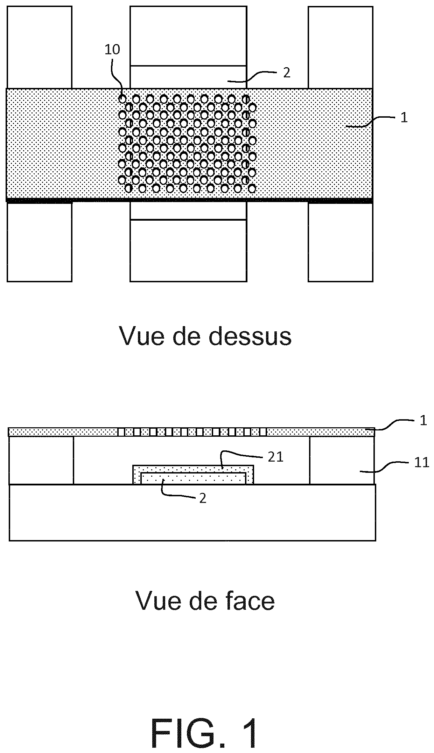

La figure 1 représente une vue de dessus et une vue de face d'un commutateur MEMS-RF électrostatique selon l'art antérieur. Il comporte une membrane 1 disposée au-dessus d'une électrode conductrice 2. La membrane est rectangulaire et plane à l'état de repos. Elle est percée de micro-trous 10 régulièrement espacés utilisés lors de sa fabrication. Sa largeur est de l'ordre de 100 micromètres, sa longueur de l'ordre de 300 micromètres et son épaisseur de l'ordre du micromètre. Elle repose sur deux piliers 11 parallèles au-dessus de l'électrode conductrice 2. Sa hauteur au-dessus de l'électrode est de quelques micromètres. L'électrode comporte une couche 21 de diélectrique dont l'épaisseur est généralement comprise entre 50 nm et 500 nm. L'ensemble membrane-électrode est équivalent à un condensateur électrique.

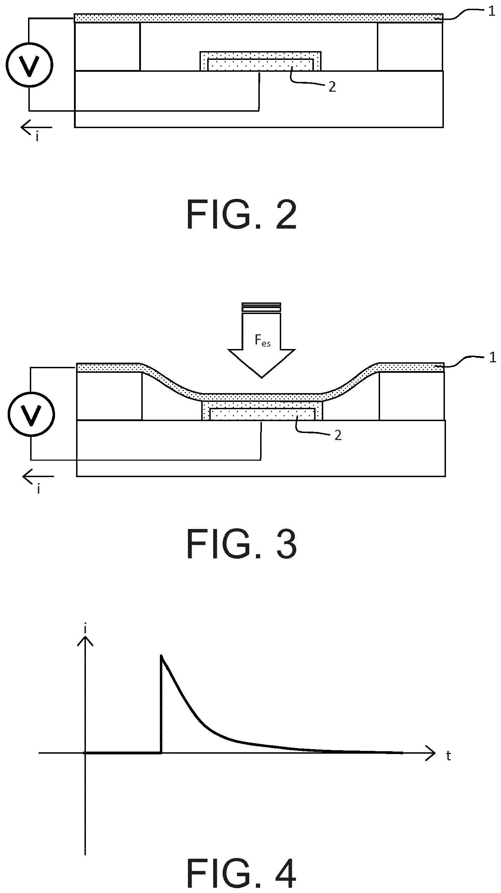

Les figures 2 à 4 représentent les différentes étapes d'une activation électrostatique de ce commutateur permettant de passer de l'état « ouvert » (haut) à l'état « fermé » (bas). Dans une première étape représentée en figure 2, on applique une tension V entre l'électrode 2 et la membrane 1. Cette tension génère une force électrostatique $F_{es}$ qui dépend des paramètres géométriques de l'ensemble constitué par la membrane et l'électrode et de la tension appliquée V. Cette force électrostatique est suffisante pour plaquer la membrane sur la couche 21 de diélectrique de l'électrode 2 comme on le voit sur la figure 3. Au cours de la charge de la capacité, un courant i circule pendant un court instant, de l'ordre de grandeur du temps de commutation de la membrane, comme on le voit sur la figure 4 qui représente la variation de l'intensité du courant en fonction du temps t. L'intensité de ce courant i est de l'ordre de quelques milliampères.

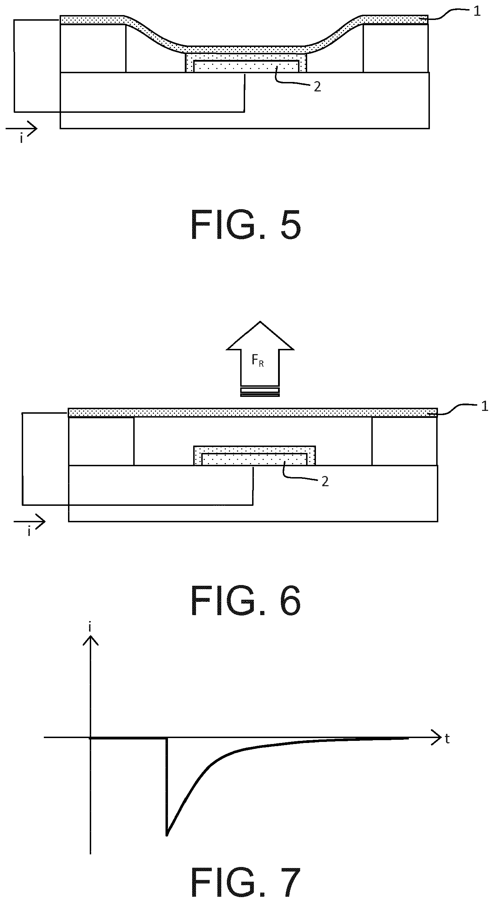

De la même façon, les figures 5 à 7 représentent les différentes étapes d'une activation électrostatique de ce commutateur permettant de passer de l'état « fermé » à l'état « ouvert ». Dans une première étape représentée en figure 5, on remet à zéro la tension V entre l'électrode 2 et la membrane 1. La force électrostatique $F_{es}$ diminue jusqu'à disparaitre, en quelques dizaines de nanosecondes, la force de rappel $F_r$ mécanique de la membrane devient la seule à s'exercer. Cette force est suffisante pour que la membrane reprenne sa position initiale comme on le voit sur la figure 6. En remettant la tension à zéro, un courant i circule de nouveau pendant un très court instant, de l'ordre de quelques dizaines de nanosecondes comme on le voit sur la figure 7 qui représente la variation de l'intensité du courant en fonction du temps t. L'intensité de ce courant est également de l'ordre de quelques milliampères.

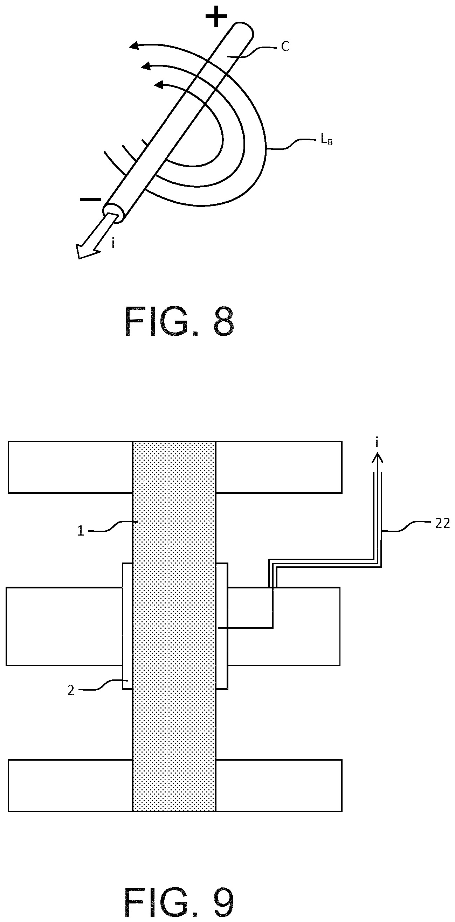

Le principe de réalisation du commutateur selon l'invention est basé sur l'apparition de ces courants transitoires pendant les phases d'activation et de désactivation de la membrane. Les effets de ces courants sont insignifiants pendant l'activation et appréciables pendant la désactivation. En effet, tout courant circulant dans un conducteur génère un champ magnétique circulant autour de ce conducteur comme on le voit sur la figure 8 qui représente un conducteur cylindrique C traversé par un courant i et les lignes concentriques $L_B$ de champ magnétiques générées par ce courant. Tout champ magnétique exerce une force sur un matériau ferromagnétique disposé dans ce champ. Par conséquent, en utilisant des matériaux ferromagnétiques pour la réalisation de la membrane et de son électrode associée, il est possible de créer une force magnétique qui va s'exercer sur la membrane à l'activation en tant que force attractive et à la désactivation en tant que force répulsive.

Pour que l'intensité du courant provoque une orientation correcte de cette force magnétique, il est nécessaire que la ligne de commande soit positionnée de façon à générer une circulation de courant générant des lignes de champs dans le sens approprié tel que représenté sur les figures 8, 10 et 11. A titre d'exemple, un agencement correct de la ligne de commande 22 est illustré en figure 9 qui représente une vue de dessus de l'ensemble membrane-électrode.

L'inclusion de matériaux ferromagnétiques dans la membrane et dans l'électrode basse permet de focaliser les champs magnétiques créés lors de la charge et de la décharge des électrodes. On génère ainsi une force supplémentaire d'attraction lors de la charge et une force supplémentaire de répulsion lors de la décharge.

Préférentiellement, la membrane est réalisée dans un alliage de samarium-cobalt qui présente les avantages de posséder une aimantation rémanente Mr élevée, de l'ordre du tesla, un champ coercitif Hc important de l'ordre de 1000 kA/m et une température maximale d'utilisation de l'ordre de 250 à 300° C. Au-delà de cette température, la perte d'aimantation devient permanente.

Les propriétés de ce matériau assurent à la membrane une robustesse élevée et une durée de vie très importante. Par ailleurs, ce matériau peut être déposé en couche mince par des techniques classiques comme l'évaporation sous vide ou la pulvérisation cathodique.

D'autres familles de matériaux peuvent être utilisées comme la famille des néodyme-fer-bore qui présentent une aimantation rémanente et des champs coercitifs plus importants que la famille des samarium-cobalt mais dont la stabilité en température est plus faible. On citera également les hexa-ferrites qui présentent, cette fois, une aimantation permanente et des champs coercitifs plus faibles que les aimants en samarium-cobalt.

Préférentiellement, la couche déposée sur l'électrode est un matériau magnétique « doux » de façon à amplifier la force magnétique entre la membrane et l'électrode. Plusieurs matériaux ont les propriétés souhaitées. On peut utiliser un alliage conducteur en fer-nickel à faible champ coercitif et forte aimantation. Ce matériau peut être déposé en couche mince par des techniques classiques comme l'évaporation sous vide ou la pulvérisation cathodique.

On peut également utiliser un ferrite isolant de type ferrite spinelle de nickel-zinc pour obtenir en plus un effet capacitif. Ce matériau possède une perméabilité relative pouvant aller jusqu'à 250-300 en fonction de la stoechiométrie et de la phase cristalline du matériau déposé. Là encore, ce matériau peut être déposé en couche mince par des techniques classiques comme l'évaporation sous vide ou la pulvérisation cathodique ou encore par ablation laser, technique connue sous l'acronyme « PLD », signifiant « Pulsed Laser Déposition ».

Le courant généré pendant les phases d'activation et de désactivation étant faible, les forces magnétiques générées restent faibles. Elles sont inversement proportionnelles à la distance séparant la membrane de l'électrode.

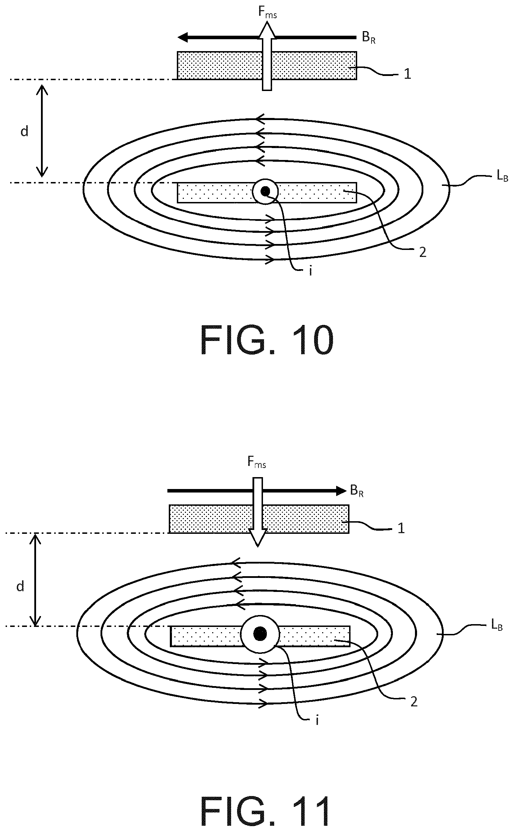

La figure 10 représente cette force magnétique $F_{ms}$ en mode répulsion, pendant la phase de désactivation et la figure 11 représente cette force magnétique $F_{ms}$ en mode attraction, pendant la phase d'activation. Sur ces figures 10 et 11, les conventions suivantes ont été adoptées, le point cerclé représente la direction du courant i circulant dans l'électrode 2, les lignes elliptiques représentent les lignes de champ magnétiques $L_B$ créées par ce courant, la flèche noire horizontale représente le champ rémanent $B_R$ dans la membrane, la flèche blanche verticale représente la force magnétique $F_{ms}$ s'exerçant sur la membrane.

Comme on le voit sur la figure 2, lors de la charge, la distance séparant la membrane de son électrode de commande est importante, le courant de charge est faible et l'effet de la force magnétique est relativement négligeable.

Lors de la décharge représentée en figure 5, l'effet est bien plus significatif. En effet, le courant de décharge est plus important même s'il dure moins longtemps que le courant de charge. Par ailleurs, la distance d séparant la membrane de son électrode est beaucoup plus faible. Ainsi, l'effet de répulsion n'est pas négligeable et contribue à faire décoller la membrane 1 de l'électrode 2.

Plus précisément, soit un commutateur MEMS RF selon l'invention comportant une membrane métallique mobile et une électrode et dont la membrane est à l'état bas, au plus près de l'électrode. On considère que le circuit de commande simplifié est constitué simplement d'un retour à la masse via une résistance R. On définit les notifications suivantes :

A : surface en regard de la membrane et de l'électrode
d : distance séparant la membrane de l'électrode à l'état bas, distance correspondant à l'épaisseur de diélectrique

D : distance séparant la membrane de l'électrode à l'état haut

$\varepsilon_0$ : permittivité du vide

$\varepsilon_r$ : permittivité relative de la couche recouvrant l'électrode

$\mu_0$ : perméabilité du vide

$\mu_r$ : perméabilité relative de la couche recouvrant l'électrode

$B_r$ : induction rémanente du matériau magnétique de la membrane

C : capacité de l'ensemble membrane-électrode

On a la relation classique :

$$C = \varepsilon_0 . \varepsilon_r . \frac{A}{d}$$

A l'instant $t_0$ où le circuit de commande passe de la tension initiale $V_0$ à 0 volt, la tension V(t) aux bornes du condensateur en fonction du temps t est donnée par l'expression :

$$V(t) = V_0 . \exp\left(-\frac{t}{RC}\right)$$

Le courant de décharge de la capacité au travers de la résistance de charge r est donnée par l'expression suivante :

$$i(t) = C . \frac{dV}{dt}$$

$$i(t) = \frac{V_0}{R} . \exp\left(-\frac{t}{RC}\right)$$

soit encore

Par conséquent, le courant maximal i(t) vaut, à l'instant initial $t_0$ :

$$i(t_0) = \frac{V_0}{R}$$

Ce courant génère un champ magnétique $\vec{B}(M)$ dont l'intensité B(t), à l'instant $t_0$ vaut :

$$B(t_0) = \frac{\mu_0 . i(t_0)}{2\pi . d}$$

La force de répulsion magnétique $F_{ms}(t_0)$ à l'instant $t_0$ générée par ce champ magnétique $B_0$ sur la membrane d'épaisseur e peut être approximée par l'expression suivante :

$$F_{ms}(t_0) = \frac{\mu_r . B(t_0) . B_r . A . e}{\mu_0 . d} \ ,$$

soit encore

$$F_{ms}(t_0) = \frac{\mu_r . i(t_0) . B_r . A . e}{2\pi . d^2} = \frac{\mu_r . V_0 . B_r . A . e}{2\pi . d^2 . R} \qquad \text{Equation 1}$$

A l'instant initial $t_0$, deux autres forces s'exercent sur la membrane. La première est une force de rappel mécanique. Elle s'ajoute à la force magnétostatique. Cette force $F_r$ vaut à l'instant initial :

$$F_r(t_0) = k.D \qquad \text{Equation 2}$$

k étant la constante de raideur de la membrane.

La seconde force est la force électrostatique $F_{es}$ qui est due à la capacité de la membrane qui est encore chargée. Elle s'oppose à la force magnétostatique. Cette force $F_{es}$ vaut à l'instant initial :

$$F_{es}(t_0) = \frac{\varepsilon_0.\varepsilon_r.A.V_0^2}{2.d^2} \qquad \text{Equation 3}$$

A titre d'exemple non limitatif, pour donner des ordres de grandeurs, la membrane est constituée d'un alliage magnétique en samarium-cobalt de formule chimique $SmCo_5$, d'une épaisseur e de 1 $\mu$m, présentant une aimantation rémanente $B_r$ de 1 tesla orientée conformément aux figures 10 et 11. La membrane est soumise à une tension $V_0$ de 40 volts, la résistance de charge valant 10 kOhms.

Le matériau magnéto-diélectrique utilisé sur l'électrode est un ferrite spinelle de formule chimique $Ni_{0.5}Zn_{0.5}Fe_2O_4$. Il présente une permittivité relative $\varepsilon_r$ de 10 et une perméabilité relative $\mu_r$ de 20. Il a une hauteur d de 200 nm et la surface A en regard de la membrane et de l'électrode vaut 100 $\mu$m par 100 $\mu$m.

Avec ces différents paramètres, la capacité C vaut 4.4 pF, le courant initial $i(t_0)$ vaut 4 mA, le champ magnétique $B(t_0)$ vaut $4.10^{-3}$ T, la force magnétostatique $F_{ms}(t_0)$ vaut $3.2.10^{-3}$ N, la force de rappel $F_r(t_0)$ vaut $6.10^{-5}$ N et la force électrostatique $F_{es}(t_0)$ vaut $1.8.10^{-2}$ N.

Par conséquent, la force électrostatique est, à l'instant initial où la tension est coupée, supérieure à la somme de la force de rappel mécanique et de la force magnétostatique.

Cette force, à l'instant initial, est suffisante pour maintenir la membrane plaquée contre l'électrode. Cependant, comme on le voit dans l'équation 3, cette force d'attraction décroît avec le carré de la tension V alors que la force de répulsion magnétostatique décroît linéairement avec la tension V comme on le voit dans l'équation 1, sa décroissance est donc moins rapide. La force de rappel mécanique est indépendante de la tension V.

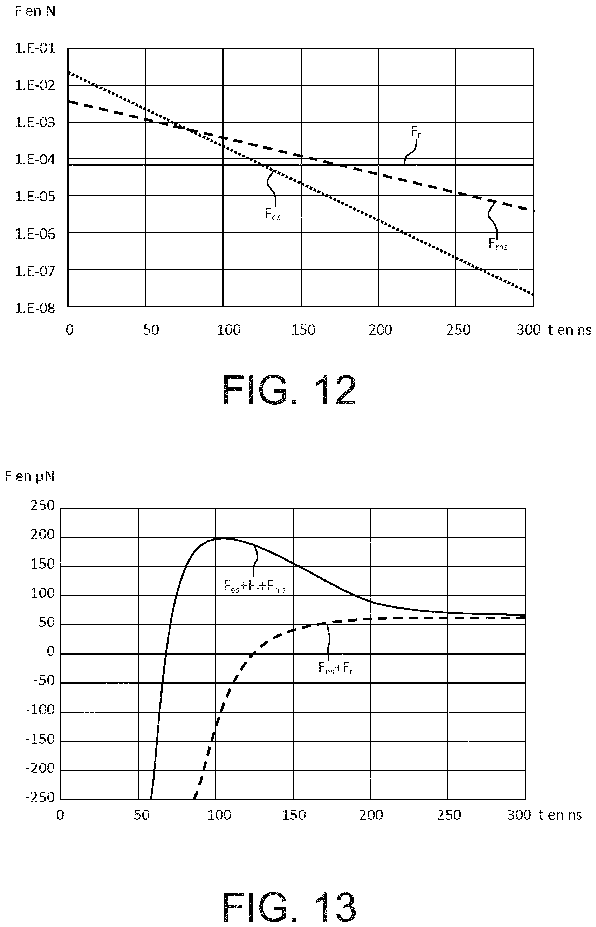

Les courbes de la figure 12 représentent l'évolution de ces trois forces en newtons au cours du temps, l'échelle des temps partant de l'instant initial et s'étendant jusqu'à 300 ns, l'échelle des newtons étant logarithmique. La première courbe en traits pointillés fins représente la force électrostatique $F_{es}(t)$, la seconde courbe en traits pointillés espacés représente la force magnétostatique $F_{ms}(t)$ et la troisième courbe en trait continu représente la force de rappel $F_r(t)$.

La première courbe de la figure 13 en pointillés représente la résultante des forces s'exerçant sur la membrane dans le cas où il y a absence de la force de répulsion magnétostatique. La seconde courbe en traits continus de la figure 13 représente la résultante des forces s'exerçant sur la membrane dans le cas où il y a présence de la force de répulsion magnétostatique. La première courbe est donc représentative d'un MEMS selon l'art antérieur et la seconde courbe d'un MEMS selon l'invention.

Dans le premier cas, la force de rappel l'emporte sur la force électrostatique au bout de 125 ns, dans le second cas, la force de répulsion magnétostatique l'emporte sur la force électrostatique au bout de 75 ns, soit un gain de temps de 50 ns qui n'est pas négligeable, compte-tenu des temps de réaction de ce type de composant. De plus, le maximum de la force résultante lorsqu'il y a présence de la force magnétostatique est supérieur d'environ 150 $\mu$N à celui de la force résultante lorsqu'il y a absence de la force magnétostatique, facilitant d'autant le décollage de la membrane et accélère son retour à l'état haut.

Ainsi, un commutateur MEMS-RF selon l'invention a de meilleures performances tant en temps de remontée qu'en force de rappel qu'un commutateur MEMS-RF selon l'art antérieur.

## Revendications

1. Commutateur MEMS-RF capacitif comportant une membrane métallique (1) disposée au-dessus d'une électrode de commande (2), apte à ce qu'une tension V appliquée entre ladite membrane et ladite électrode génère une force électrostatique $F_{es}$ suffisante pour passer d'un état « ouvert » à un état « fermé » durant un temps de commutation et génère un courant transitoire i pendant un court instant de l'ordre du temps de commutation ou apte à ce que la tension V remise à zéro, pour passer d'un état « fermé » à un état « ouvert » génère également un courant transitoire durant un temps de commutation, **caractérisé en ce que** la membrane et l'électrode de commande sont réalisées en matériaux ferromagnétiques ou comportent au moins une couche de matériau ferromagnétique, un courant transitoire générant un champ magnétique et par conséquences une force magnétique de rappel qui s'exerce sur la membrane à l'activation en tant que force attractive et à la désactivation en tant que force répulsive aux instants de commutation de l'électrode de commande,.

2. Commutateur MEMS-RF selon la revendication 1, **caractérisé en ce qu'**au repos, la membrane étant sensiblement plane et maintenue au-dessus de l'électrode de commande par deux piliers, la déformation de la membrane se faisant selon un axe perpendiculaire à ce plan et selon une direction joignant les deux piliers, l'électrode de commande étant alimentée par une ligne (22) de commande en courant, ladite ligne de commande est disposée de façon que le sens de l'intensité du courant soit perpendiculaire audit axe et à ladite direction de façon que les forces magnétiques créées par ledit courant soient parallèles à l'axe de déformation.

3. Commutateur MEMS-RF selon l'une des revendications précédentes, **caractérisé en ce que** le matériau ferromagnétique de la membrane possède une aimantation permanente appelée aimantation rémanente.

4. Commutateur MEMS-RF selon la revendication 3, **caractérisé en ce que** le matériau ferromagnétique de la membrane est un alliage de samarium-cobalt ou un alliage de néodyme-fer-bore ou un hexaferrite de baryum ou de strontium.

5. Commutateur MEMS-RF selon l'une des revendications précédentes, **caractérisé en ce que** le matériau ferromagnétique de l'électrode de commande est un alliage conducteur en fer-nickel.

6. Commutateur MEMS-RF selon l'une des revendications 1 à 4, **caractérisé en ce que** le matériau ferromagnétique de l'électrode de commande est un ferrite isolant.

7. Commutateur MEMS-RF selon la revendication 6, **caractérisé en ce que** ferrite isolant est un ferrite spinelle de nickel-zinc.

8. Commutateur MEMS-RF selon l'une des revendications précédentes, **caractérisé en ce que** la couche de matériau ferromagnétique est déposée par évaporation sous vide ou par pulvérisation cathodique ou par dépôt par ablation laser.

9. Commutateur MEMS-RF selon l'une des revendications précédentes, **caractérisé en ce que** l'épaisseur de la membrane est comprise entre 0.5 micromètre et 1.5 micromètre.

10. Commutateur MEMS-RF selon l'une des revendications précédentes, **caractérisé en ce que** l'épaisseur de la couche de matériau ferromagnétique de l'électrode est comprise entre 100 nanomètres et 300 nanomètres.

11. Commutateur MEMS-RF selon l'une des revendications précédentes, **caractérisé en ce que** la largeur de la membrane est comprise entre 50 micromètres et 150 micromètres et sa longueur est comprise entre 200 micromètres et 400 micromètres.

**Patentansprüche**

1. Kapazitiver MEMS-RF-Schalter, umfassend eine metallische Membran (1), die oberhalb einer Steuerelektrode (2) angeordnet ist, der dazu geeignet ist, dass eine Spannung V, die zwischen der Membran und der Elektrode angelegt wird, eine elektrostatische Kraft $F_{es}$ erzeugt, die ausreicht, um während einer Umschaltzeit von einem Zustand "geöffnet" zu einem Zustand "geschlossen" überzugehen, und während eines kurzen Moments in der Größenordnung der Umschaltzeit einen transienten Strom i erzeugt, oder der dazu geeignet ist, dass die Spannung V, die auf null zurück gestellt ist, um von einem Zustand "geschlossen" zu einem Zustand "geöffnet" überzugehen, auch während einer Umschaltzeit einen transienten Strom erzeugt, **dadurch gekennzeichnet, dass** die Membran und die Steuerelektrode aus einem ferromagnetischen Material gefertigt sind oder aus mindestens einer Schicht aus einem ferromagnetischen Material bestehen, wobei ein transienter Strom ein Magnetfeld und folglich eine magnetische Rückführungskraft erzeugt, die während der Umschaltmomente der Steuerelektrode bei Aktivierung als Anziehungskraft und bei Deaktivierung als Abstoßkraft auf die Membran wirkt.

2. MEMS-RF-Schalter nach Anspruch 1, **dadurch gekennzeichnet, dass**, da die Membran in der Ruhestellung im Wesentlichen eben ist und durch zwei Ständer oberhalb der Steuerelektrode gehalten wird, die Verformung der Membran entlang einer Achse senkrecht zu dieser Ebene und entlang einer Richtung, die die beiden Ständer verbindet, erfolgt, die Steuerelektrode durch eine Stromsteuerleitung (22) versorgt wird, die Steuerleitung derart angeordnet ist, dass die Richtung der Stromstärke derart senkrecht zu der Achse und zu der Richtung ist, dass die durch den Strom erzeugten Magnetkräfte parallel zu der Verformungsachse sind.

3. MEMS-RF-Schalter nach einem der vorhergehenden Ansprüche, **dadurch gekennzeichnet, dass** das ferromagnetische Material der Membran eine dauerhafte Magnetisierung besitzt, die als remanente Magnetisierung bezeichnet wird.

4. MEMS-RF-Schalter nach Anspruch 3, **dadurch gekennzeichnet, dass** das ferromagnetische Material der Membran eine Samarium-Kobalt-Legierung oder eine Neodym-Eisen-Bor-Legierung oder ein Bariumhexaferrit oder Strontiumhexaferrit ist.

5. MEMS-RF-Schalter nach einem der vorhergehenden Ansprüche, **dadurch gekennzeichnet, dass** das ferromagnetische Material der Steuerelektrode eine leitfähige Eisen-Nickel-Legierung ist.

6. MEMS-RF-Schalter nach einem der Ansprüche 1 bis 4, **dadurch gekennzeichnet, dass** das ferromagnetische Material der Steuerelektrode ein isolierender Ferrit ist.

7. MEMS-RF-Schalter nach Anspruch 6, **dadurch gekennzeichnet, dass** der isolierende Ferrit ein Nickel-Zink-Spinellferrit ist.

8. MEMS-RF-Schalter nach einem der vorhergehenden Ansprüche, **dadurch gekennzeichnet, dass** die Schicht aus ferromagnetischem Material durch Vakuumverdampfung oder durch Kathodenzerstäubung oder durch Laserablationsablagerung aufgebracht wird.

9. MEMS-RF-Schalter nach einem der vorhergehenden Ansprüche, **dadurch gekennzeichnet, dass** die Dicke der Membran zwischen 0,5 Mikrometern und 1,5 Mikrometern liegt.

10. MEMS-RF-Schalter nach einem der vorhergehenden Ansprüche, **dadurch gekennzeichnet, dass** die Dicke der Schicht aus ferromagnetischem Material der Elektrode zwischen 100 Nanometern und 300 Nanometern liegt.

11. MEMS-RF-Schalter nach einem der vorhergehenden Ansprüche, **dadurch gekennzeichnet, dass** die Breite der Membran zwischen 50 Mikrometern und 150 Mikrometern und ihre Länge zwischen 200 Mikrometern und 400 Mikrometern liegt.

**Claims**

1. A capacitive RF-MEMS switch comprising a metallic membrane (1) positioned above a control electrode (2), adapted in such a way that a voltage V applied between said membrane and said electrode generates an electrostatic force $F_{es}$ sufficient to move from an "open" state to a "closed" state during a switching time and generates a transitory current i during a short moment in the order of the switching time or in such a way that the voltage V, which returns to zero, in order to move from a "closed" state to an "open" state, also generates a transitory current during a switching time, **characterised in that** the membrane and the control electrode are made of ferromagnetic materials or contain at least one layer of ferromagnetic material, a transitory current generating a magnetic field and consequently a magnetic return force which acts on the membrane for activation as an attractive force and for deactivation as a repulsive force at the switching moments of the control electrode.

2. The RF-MEMS switch according to claim 1, **characterised in that** when at rest, the membrane being substantially planar and held above the control electrode by two pillars, the membrane deforming along an axis that is perpendicular to this plane and in a direction joining the two pillars, the control electrode being supplied with a current control line (22), said control line is positioned such that the direction of the current intensity is perpendicular to said axis and to said direction such that the magnetic forces created by said current are parallel to the axis of deformation.

3. The RF-MEMS switch according to one of the preceding claims, **characterised in that** the ferromagnetic material of the membrane possesses a permanent magnetisation called remanent magnetisation.

4. The RF-MEMS switch according to claim 3, **characterised in that** the ferromagnetic material of the membrane is a samarium-cobalt alloy or a neodymium-iron-boron alloy or a barium or strontium hexaferrite.

5. The RF-MEMS switch according to one of the preceding claims, **characterised in that** the ferromagnetic material of the control electrode is a conductive iron-nickel alloy.

6. The RF-MEMS switch according to one of claims 1 to 4, **characterised in that** the ferromagnetic material of the control electrode is an insulating ferrite.

7. The RF-MEMS switch according to claim 6, **characterised in that** the insulating ferrite is a nickel-zinc spinel ferrite.

8. The RF-MEMS switch according to one of the preceding claims, **characterised in that** the layer of ferromagnetic material is deposited by vacuum evaporation or cathode sputtering or laser ablation deposition.

9. The RF-MEMS switch according to one of the preceding claims, **characterised in that** the thickness of the membrane is between 0.5 micrometres and 1.5 micrometres.

10. The RF-MEMS switch according to one of the preceding claims, **characterised in that** the thickness of the layer of ferromagnetic material of the electrode is between 100 nanometres and 300 nanometres.

11. The RF-MEMS switch according to one of the preceding claims, **characterised in that** the width of the membrane is between 50 micrometres and 150 micrometres and its length is between 200 micrometres and 400 micrometres.

Vue de dessus

Vue de face

# FIG. 1

FIG. 2

FIG. 3

FIG. 4

# FIG. 5

# FIG. 6

# FIG. 7

FIG. 8

FIG. 9

## FIG. 10

## FIG. 11

F en N

FIG. 12

F en µN

FIG. 13

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2005248423 A1
- WO 2015199721 A1